# EUROPÄISCHE PATENTSCHRIFT

(11) **EP 2 920 599 B1**
(45) Veröffentlichungstag und Bekanntmachung des Hinweises auf die Patenterteilung: **12.08.2020**
(21) Anmeldenummer: 13792634.1
(22) Anmeldetag: 11.11.2013
(51) Int. Cl.: G01R 31/396, H01M 10/42, H02J 7/00

(54) **PRÜFANORDNUNG FÜR EINEN ENERGIESPEICHER**
TESTING ASSEMBLY FOR AN ENERGY STORAGE DEVICE
MONTAGE D'ESSAI POUR UN ACCUMULATEUR D'ÉNERGIE

(30) Priorität: 14.11.2012 AT 505132012
(43) Veröffentlichungstag der Anmeldung: 23.09.2015
(73) Patentinhaber: AVL List GmbH, 8020 Graz (AT)
(72) Erfinder: SCHIPFER, Gottfried, A-8521 Wettmannstätten (AT); PROCHART, Günter, A-8042 Graz (AT)
(74) Vertreter: Patentanwälte Pinter & Weiss OG
(86) Internationale Anmeldenummer: PCT/EP2013/073504
(87) Internationale Veröffentlichungsnummer: WO 2014/076033

(56) Entgegenhaltungen:
- WO-A2-97/07385
- US-B1- 6 344 985

## Beschreibung

Die gegenständliche Erfindung betrifft eine Prüfanordnung für einen Energiespeicher mit zumindest einem Energiespeichermodul mit einer Mehrzahl von Energiespeichereinheiten, mit einem Wechselstrom-Gleichstromwandler, der eingangsseitig mit einer Spannungsversorgung verbunden ist und ausgangsseitig mit zumindest einem bidirektionalen isolierten Modul-Gleichstrom-Gleichstromwandler verbunden ist, wobei der Ausgang des bidirektionalen isolierten Modul-Gleichstrom-Gleichstromwandlers mit einer Mehrzahl von parallel geschalteten Zell-Gleichstrom-Gleichstromwandlern verbunden ist und die Ausgänge der Zell-Gleichstrom-Gleichstromwandler als Ausgänge der Prüfanordnung nach außen geführt sind, sowie die Verwendung einer solchen Prüfanordnung in einem Test- und Formiersystem.

Aktuelle Zelltester arbeiten großteils mit ineffizienten linearen Lagereglern und setzen die gesamte Entladeenergie in Wärme um. Dadurch entstehen hohe Kosten für leistungsfähige Kühlsysteme und hohe Energiekosten bei der Produktion und dem Testen von Batterien, z.B. für Formierung, Qualitätsprüfung, Langzeittests, Emulation, etc.

Vereinzelt werden auch rückspeisefähige Schaltwandler für Zelltester eingesetzt, diese sind aufwendig, teuer und weisen einen schlechten Wirkungsgrad auf, da diese ein sehr hohes Spannungsverhältnis abbilden müssen, z.B. von 3V auf 400V hochsetzen. Einen solchen Schaltwandler zum Testen von Batterien zeigt z.B. die WO 97/07385 A2, in der eine Anzahl bidirektionaler DC/DC-Konverter an einen AC/DC-Konverter angeschlossen sind. Die US 6 344 985 B1 behandelt ebenso einen bidirektionalen DC/DC-Konverter, in dem auch eine Parallelschaltung von einzelnen Modulen vorgesehen ist.

Es ist eine Aufgabe der gegenständlichen Erfindung, eine effiziente, kostengünstige und gleichzeitig flexibel einzusetzende bzw. konfigurierbare Prüfanordnung anzugeben.

Diese Aufgabe wird erfindungsgemäß dadurch gelöst, indem mehrere Modul-Gleichstrom-Gleichstromwandler parallel an den Ausgang des Wechselstrom-Gleichstromwandlers angeschlossen sind, wobei jeder Modul-Gleichstrom-Gleichstromwandler mit einer Mehrzahl von parallel geschalteten Zell-Gleichstrom-Gleichstromwandlern verbunden ist und die Ausgänge der Modul-Gleichstrom-Gleichstromwandler über Schalter in Serie verschaltbar sind, oder die Ausgänge mehrerer Zell-Gleichstrom-Gleichstomwandler über Schalter in Serie verschaltbar sind. Durch diesen hierarchischen Aufbau der Prüfanordnung mittels isolierter Gleichstrom-Gleichstromwandler kann die Prüfanordnung äußerst flexibel konfiguriert werden, insbesondere sind damit unterschiedlichste Ausbaustufen möglich. Von einzelnen Energiespeichereinheiten bis zu einzelnen Energiespeichermodule und ganze Energiespeicher können damit getestet und formiert werden, ohne den internen Aufbau der Prüfanordnung ändern zu müssen. Die Änderung der Konfiguration kann dabei sehr einfach über steuerbare Schalter erfolgen.

Grundsätzlich ist die Effizienz eines Wandlers bekanntermaßen mit höherer Leistung und mit höherer Spannungslage besser. Im vorliegenden hierarchischen Aufbau der Prüfanordnung hat der Wechselstrom-Gleichstromwandler einem Wirkungsgrad von ∼ 92%, die Modul-Gleichstrom-Gleichstromwandler einen Wirkungsgrad von ∼85% und die Zell-Gleichstrom Gleichstromwandler einen Wirkungsgrad von ∼75%. Daher wird versucht, die Energie für das Testen und Emulieren wann immer es möglich ist mit der höchsten Wandler Stufe (Wechselstrom-Gleichstromwandler) zur Verfügung zu stellen, was aufgrund des vorliegenden Aufbaus möglich ist. Für viele Testfälle, insbesondere bei Anwendung als Test- und Emulationssystem für Batterien, werden alle Energiespeichereinheiten (z.B. die Batteriezellen) über lange Zeit mit der gleichen Sollgröße getestet. Z.B. können bei einem Ladezyklus sämtliche Energiespeichereinheiten fast die ganzen CC-Phase (constant current) über von der höchsten Wandler Stufe (Wechselstrom-Gleichstromwandler) versorgt werden. Erst beim Übergang in die CV-Phase (constant voltage) müssen die Modul-, bzw. Zell Gleichstrom-Gleichstromwandler eingreifen. Damit ergibt sich ein Wirkungsgrad Vorteil von ∼92-75% = 17% für üblicherweise mehr als 50% der Testzeit. Daher erlaubt die erfindungsgemäße Prüfanordnung auch mit bestmöglichem Wirkungsgrad arbeiten zu können.

Zum Testen oder Formieren wird einfach eine Energiespeichereinheit des Energiespeichermoduls mit einem Ausgang eines Zell-Gleichstrom-Gleichstromwandlers verbunden. Damit kann die Energiespeichereinheit auf Ebene des Zell-Gleichstrom-Gleichstromwandlers mit einem vorgebbaren Ladestrom beaufschlagt werden.

Da die Ausgänge eines Modul-Gleichstrom-Gleichstromwandlers mit den seriell verschalteten Ausgängen der zugehörigen in Serie geschalteten Zell-Gleichstrom-Gleichstromwandler verbunden sind, kann auch bei Verwendung von unidirektionalen Zell-Gleichstrom-Gleichstromwandlern entladen werden. Dazu können alle Energiespeichereinheiten entladen werden, indem alle Zell-Gleichstrom-Gleichstromwandler inaktiv geschaltet werden. Es können aber auch einzelne Energiespeichereinheiten mit einem beliebigen Laststrom beaufschlagt werden, indem der Strom des zugehörigen Modul-Gleichstrom-Gleichstromwandlers durch einen Strom des Zell-Gleichstrom-Gleichstromwandlers überlagert wird.

Größere Energiespeicher lassen sich testen und formieren, wenn mehrere Modul-Gleichstrom-Gleichstromwandler parallel an den Ausgang des Wechselstrom-Gleichstromwandlers angeschlossen sind und jeder Modul-Gleichstrom-Gleichstromwandler mit einer Mehrzahl von parallel geschalteten Zell-Gleichstrom-Gleichstromwandlern verbunden ist. Damit lassen sich beliebige Ausbaustufen und Konfigurationen eines Energiespeichers testen und formieren, was die Flexibilität der Prüfanordnung erhöht.

Da die Ausgänge der Modul-Gleichstrom-Gleichstromwandler über Schalter in Serie verschaltbar sind, können auch Energiespeicher, die aus mehreren miteinander verschalteten Energiespeichermodulen bestehen, als Ganzes mit hohem Wirkungsgrad getestet oder formiert werden.

Durch Herausführen der Ausgänge der Modul-Gleichstrom-Gleichstromwandler über einen Schalter, kann die Prüfanordnung auch auf Modulebene kontaktiert werden, z.B. als Eingang für ein Batteriemanagementsystem oder um einzelne Energiespeichermodule als Ganzes zu testen oder zu formieren.

Wenn der Ausgang des Wechselstrom-Gleichstromwandlers über einen Schalter als Ausgang der Prüfanordnung nach außen geführt ist, kann die Prüfanordnung auch auf Energiespeicherebene kontaktiert werden, z.B. als Eingang für ein Batteriemanagementsystem oder um einzelne Energiespeicher als Ganzes zu testen oder zu formieren.

Die Flexibilität der Prüfanordnung kann weiter gesteigert werden, wenn die Ausgänge der in Serie geschalteten Zell-Gleichstrom-Gleichstromwandler über einen Schalter als Ausgänge der Prüfanordnung nach außen geführt sind.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt
Fig.1 eine erfindungsgemäße Prüfanordnung und
Fig.2 und 3 die Verwendung der Prüfanordnung zum Testen oder Formieren von Batteriezellen.

Die erfindungsgemäße Prüfanordnung 1 für elektrische Energiespeicher besteht aus einem bidirektionalen eingangsseitigen Wechselstrom-Gleichstromwandler 2, der über einen Eingangsanschluss 4 mit einer Spannungsversorgung 3, z.B. eine 400VAC Spannungsquelle, verbunden werden kann. Am Gleichstromausgang des Wechselstrom-Gleichstromwandlers 2, z.B. ein 400VDC Ausgang, sind parallel eine Anzahl von (zumindest ein) Modul-Gleichstrom-Gleichstromwandler 5₁ ... 5ₙ angeschlossen. Die Modul-Gleichstrom-Gleichstromwandler 5₁ ... 5ₙ sind als kommerziell erhältliche bidirektionale, isolierte Gleichstrom-Gleichstromwandler ausgeführt. Die Modul-Gleichstrom-Gleichstromwandler 5₁ ... 5ₙ wandeln den Hochvolt-DC-Ausgang des Wechselstrom-Gleichstromwandlers 2 in eine DC-Spannung um, die dem Spannungsbereich eines Energiespeichermoduls, wie z.B. ein Batteriemodul oder ein Brennstoffzellenmodul, bestehend aus einer Mehrzahl von Energiespeichereinheiten, wie z.B. Batteriezellen oder Brennstoffzellen, entspricht, z.B. 12V oder 48V DC. Die Ausgänge der Modul-Gleichstrom-Gleichstromwandler 5₁ ... 5ₙ können über Schalter SM auch in Serie geschaltet werden, was deshalb möglich ist, weil die Modul-Gleichstrom-Gleichstromwandler 5₁ ... 5ₙ als isolierte Gleichstrom-Gleichstromwandler ausgeführt sind.

Am Ausgang eines Modul-Gleichstrom-Gleichstromwandlers 5₁ ... 5ₙ sind parallel eine Anzahl von (zumindest ein) Zell-Gleichstrom-Gleichstromwandler 6₁₁ ... 6ₙₘ angeschlossen. Die Zell-Gleichstrom-Gleichstromwandler 6₁₁ ... 6ₙₘ sind als kommerziell erhältliche, isolierte Gleichstrom-Gleichstromwandler ausgeführt. Die Zell-Gleichstrom-Gleichstromwandler 6₁₁ ... 6ₙₘ können dabei aber auch als bidirektionale Gleichstrom-Gleichstromwandler ausgeführt sein. Die Zell-Gleichstrom-Gleichstromwandler 6₁₁ ... 6ₙₘ wandeln den DC-Ausgang des zugehörigen Modul-Gleichstrom-Gleichstromwandlers 5₁ ... 5ₙ in eine DC-Spannung, die dem Spannungsbereich der Energiespeichereinheit eines Energiespeichermoduls, z.B. 0,5V bis 5,5V DC bei Batteriezellen eines Batteriemoduls. Die Ausgänge der Zell-Gleichstrom-Gleichstromwandler 6₁₁ ... 6ₙₘ können über Schalter SZ auch in Serie geschaltet werden, was deshalb möglich ist, weil die Zell-Gleichstrom-Gleichstromwandler 6₁₁ ... 6ₙₘ als isolierte Gleichstrom-Gleichstromwandler ausgeführt sind

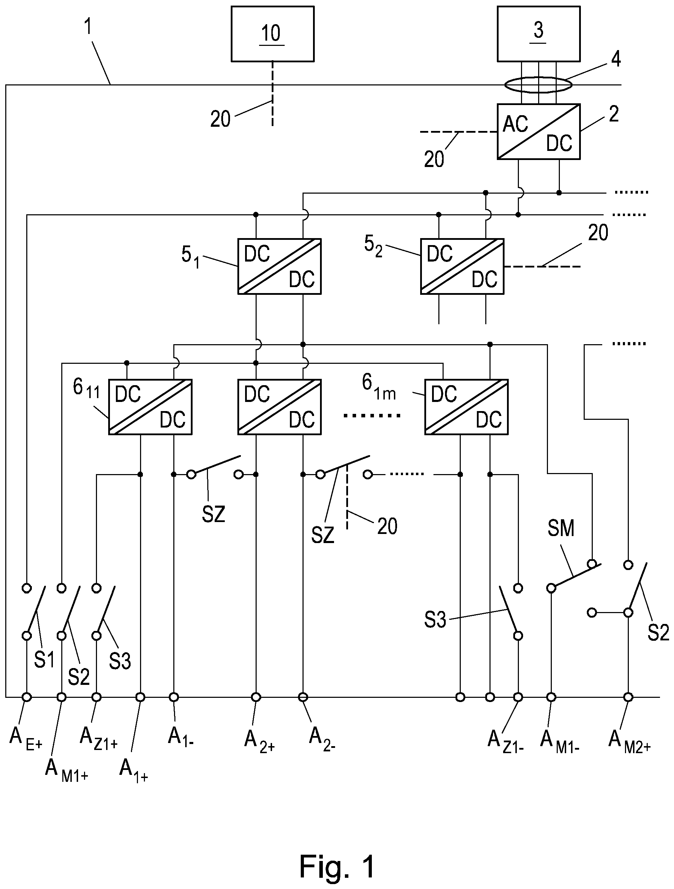

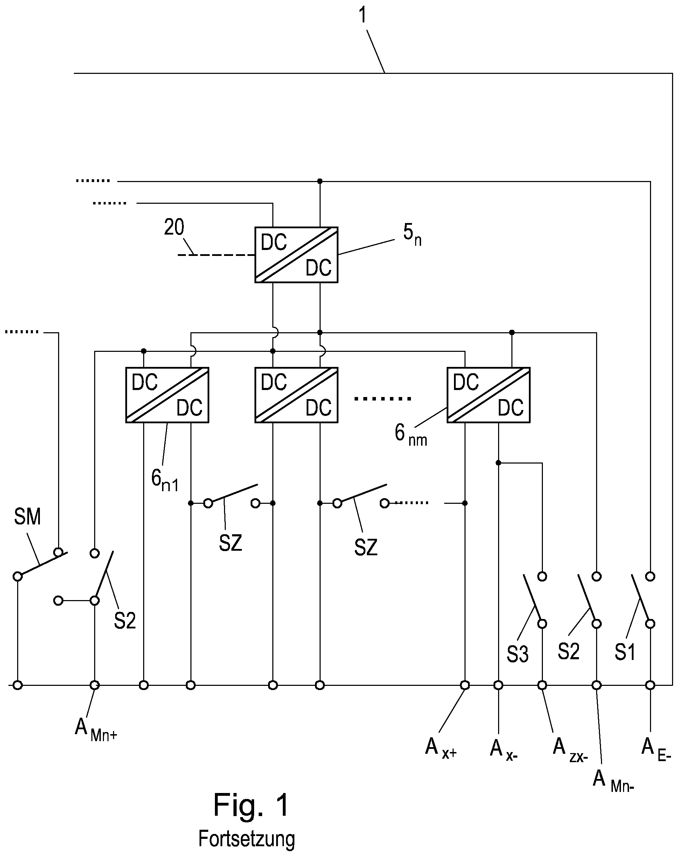

Als Ausgänge der Prüfanordnung 1 können auf Energiespeicherebene die Ausgänge A_{E+}, A_{E-} des Wechselstrom-Gleichstromwandlers 2, auf Energiespeichermodulebene die Ausgänge A_{M1+}, A_{M1-} ... A_{Mn+}, A_{Mn-} der Modul-Gleichstrom-Gleichstromwandler 5₁ ... 5ₙ und die Ausgänge A₁₊, A₁₋ ... Aₓ₊, Aₓ₋ der Zell-Gleichstrom-Gleichstromwandler 6₁₁ ... 6ₙₘ nach außen geführt sein und können elektrisch kontaktiert werden. Ebenso sind bevorzugt jeweils der erste und der letzte Ausgang A_{Z1+}, A_{Z1-} ... A_{Zx+}, A_{Zx-} der in Serie schaltbaren Zell-Gleichstrom-Gleichstromwandler 6₁₁ ... 6ₙₘ, wie in Fig.1 dargestellt, nach außen geführt.

Die Ausgänge A_{E+}, A_{E-} der Wechselstrom-Gleichstromwandlers 2 können über Schalter S1 aktiviert werden. Die Ausgänge A_{M1+}, A_{M1-} ... A_{Mn+}, A_{Mn-} der Modul-Gleichstrom-Gleichstromwandler 5₁ ... 5ₙ können durch Schalter S2 aktiviert werden. Die Ausgänge A_{Z1+}, A_{Z1-} ... A_{Zx+}, A_{Zx-} der in Serie schaltbaren Zell-Gleichstrom-Gleichstromwandler 6₁ₘ ... 6ₙₘ, also im Wesentlichen der erste und der letzte Ausgang der in Serie geschalteten Zell-Gleichstrom-Gleichstromwandler 6₁₁ ... 6ₙₘ, können durch Schalter S3 aktiviert werden.

Im Vollausbau hat eine erfindungsgemäße Prüfanordnung 1 z.B. einen Wechselstrom-Gleichstromwandler 2, an dem acht Modul-Gleichstrom-Gleichstromwandler 5₁ ... 5₈ angeschlossen sind, an denen jeweils zwölf Zell-Gleichstrom-Gleichstromwandler 6₁₁ ... 6₈₁₂ angeschlossen sind. Damit können folglich bis zu 96 Energiespeichereinheiten oder 8 Energiespeichermodule zu je 12 Energiespeichereinheiten geprüft bzw. formiert werden. Selbstverständlich sind auch andere Ausbaustufen denkbar.

Der Wechselstrom-Gleichstromwandler 2, die Modul-Gleichstrom-Gleichstromwandler 5₁ ... 5ₙ und die Zell-Gleichstrom-Gleichstromwandler 6₁₁ ... 6ₙₘ werden dabei von einer Steuereinheit 10, die auch in der Prüfanordnung 1 integriert sein kann, den Anforderungen gemäß angesteuert. Ebenso kann die Steuereinheit 10 das Öffnen / Schließen der Schalter S1, S2, S3, SM, SZ steuern. Die Steuerleitungen 20 von der Steuereinheit 10 zu den einzelnen Komponenten der Prüfanordnung 1 sind in der Fig.1 aus Gründen der Übersichtlichkeit nicht eingezeichnet bzw. nur angedeutet.

Die Funktion der erfindungsgemäßen Prüfanordnung 1 wird nachfolgend anhand eines konkreten Ausführungsbeispiels in Form eines Test- und Formiersystems für einen elektrischen Energiespeicher näher beschrieben.

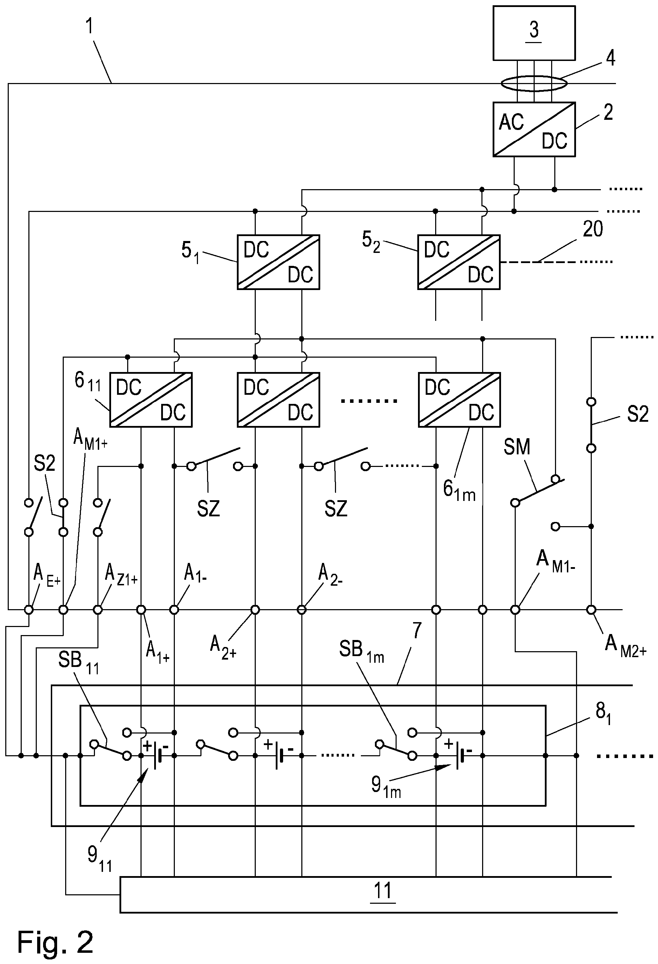

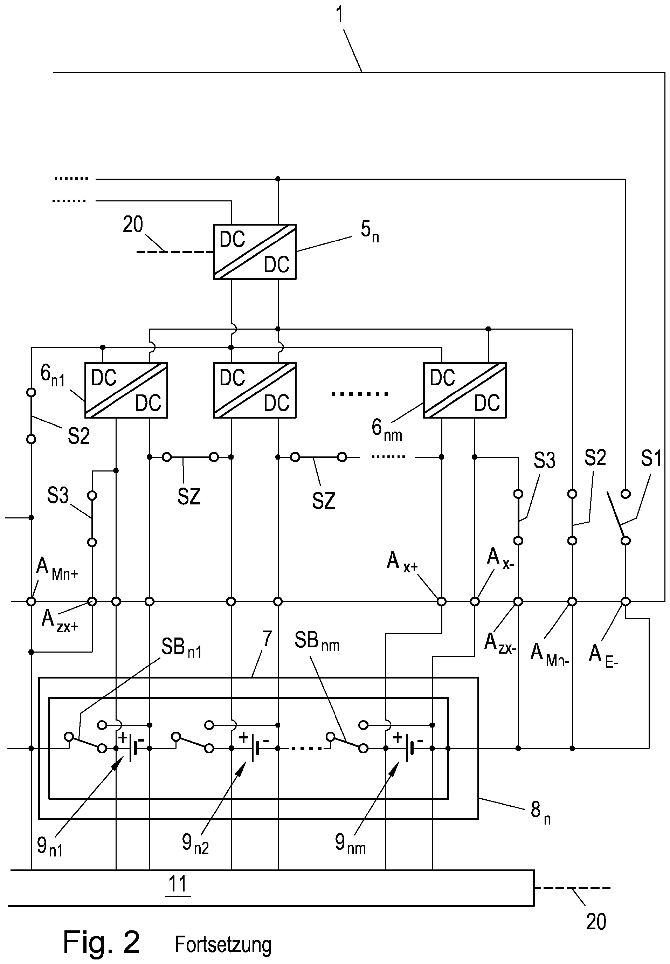

Im Beispiel nach Fig.2 wird die erfindungsgemäße Prüfanordnung 1 an ein Batteriepack 7 bestehend aus n Batteriemodulen 8₁ ... 8ₙ zu je m Batteriezellen 9₁₁ ... 9ₙₘ angeschlossen, um das Batteriepack 7 zu testen oder zu formieren. Jede Batteriezelle 9₁₁ ... 9ₙₘ ist mit dem Ausgang A₁₊, A₁₋ ... Aₓ₊, Aₓ₋ eines Zell-Gleichstrom-Gleichstromwandlers 6₁₁ ... 6ₙₘ der Prüfanordnung 1 verbunden. Die Batteriemodule 8₁ ... 8ₙ sind hier nicht in Serie geschaltet, sondern jeder Modul-Gleichstrom-Gleichstromwandler 5₁ ... 5₈ ist an jeweils ein Batteriemodul 8₁ ... 8ₙ angeschlossen. Dazu sind die Schalter S2 geschlossen und die Verbindung zwischen den Modul-Gleichstrom-Gleichstromwandler 5₁ ... 5₈ durch den Schalter SM geöffnet. Damit kann jeder Batteriezelle 9₁₁ ... 9ₙₘ ein beliebiger (innerhalb der Spannungs- und Stromkapazität der Zell-Gleichstrom-Gleichstromwandler 6₁₁ ... 6ₙₘ) Laststrom (Lade-/Entladestrom) vorgegeben werden und einzelne Batteriezellen 9₁₁ ... 9ₙₘ können unterschiedlich geladen oder entladen werden. Damit kann ein Batteriepack 7, einzelne Batteriemodule 8 oder auch einzelne Batteriezellen 9 getestet werden. Anstelle eines Batteriepacks bzw. von Batteriemodulen können auch andere Energiespeichermodule oder Energiespeicherzellen getestet werden. Jede Batteriezelle 9 bzw. jeder Batteriemodul 8 kann auch mit einem hinlänglich bekannten Batteriemanagementsystem 11 (BMS) verbunden sein. Das Batteriemanagementsystem 11 kann auch mit der Steuereinheit 10 verbunden sein, um Istwerte der Zellen bzw. der Module erfassen und verarbeiten zu können.

Bei Verwendung von unidirektionalen Zell-Gleichstrom-Gleichstromwandler 6₁₁ ... 6ₙₘ kann nur auf Energiespeichermodulebene entladen werden, wie anhand des Modul-Gleichstrom-Gleichstromwandlers 5ₙ in Fig.2 beschrieben wird. Zum Entladen der Batteriezellen 9ₙ₁ ... 9ₙₘ, die an den Zell-Gleichstrom-Gleichstromwandlern 6ₙ₁ ... 6ₙₘ des Modul-Gleichstrom-Gleichstromwandlers 5ₙ angeschlossen sind, werden die Schalter SZ und die Schalter S2, S3 geschlossen, womit die Ausgänge der Zell-Gleichstrom-Gleichstromwandler 6ₙ₁ ... 6ₙₘ in Serie geschaltet sind und über die Ausgänge A_{Zx+}, A_{Zx-} mit den Ausgängen A_{Mn+}, A_{Mn-} des Modul-Gleichstrom-Gleichstromwandlers 5ₙ verbunden sind. Der Modul-Gleichstrom-Gleichstromwandler 5ₙ legt nun einen Entladestrom an die Batteriezellen 9ₙ₁ ... 9ₙₘ an und die Zell-Gleichstrom-Gleichstromwandler 6ₙ₁ ... 6ₙₘ werden inaktiv geschaltet. Damit werden die Batteriezellen 9ₙ₁ ... 9ₙₘ allesamt mit denselben Entladestrom entladen. Wenn eine einzelne (oder mehrere) Batteriezelle 9ₙ₁ ... 9ₙₘ nicht entladen werden soll, kann der Entladestrom des Modul-Gleichstrom-Gleichstromwandlers 5ₙ durch den zugehörigen Zell-Gleichstrom-Gleichstromwandler 6ₙ₁ ... 6ₙₘ kompensiert werden, indem dieser einen gegengleichen Ladestrom erzeugt, der auf die Batteriezellen 9ₙ₁ ... 9ₙₘ wirkt.

Durch das Zusammenspiel von Zell-Gleichstrom-Gleichstromwandler 6₁₁ ... 6ₙₘ und dem dazugehörigen Modul-Gleichstrom-Gleichstromwandler 5ₙ kann in der oben angeführten Weise jede einzelnen Batteriezelle 9ₙ₁ ... 9ₙₘ mit einem beliebigen Laststrom getestet oder fromiert werden. Insbesondere kann der Strom eines Modul-Gleichstrom-Gleichstromwandler 5₁ ... 5ₙ durch einen beliebigen Strom eines Zell-Gleichstrom-Gleichstromwandler 6₁₁ ... 6ₙₘ überlagert werden, womit der Strom des Modul-Gleichstrom-Gleichstromwandler 5₁ ... 5ₙ auf Energiespeichereinheitenebene auch verstärkt werden kann.

Bei offenen Schaltern S1, S2, S3, SZ und SM liegen an den Ausgängen A₁₊, A₁₋ ... Aₓ₊, Aₓ₋ und A_{Z1+}, A_{z1-} ... A_{Zx+}, A_{zx-} der Zell-Gleichstrom-Gleichstromwandler 6₁₁ ... 6ₙₘ und den Ausgängen A_{M1+}, A_{M1-} ... A_{Mn+}, A_{Mn-} der Modul-Gleichstrom-Gleichstromwandler 5₁ ... 5ₙ nur Spannungen an, die unterhalb der Schutzkleinspannung liegen, womit hier gänzlich auf Schutz gegen Berühren verzichtet werden kann. Das ist insbesondere interessant beim Formieren von Energiespeichern.

Die Batteriezellen 9₁₁ ... 9ₙₘ können dabei über Schalter SB₁₁ ... SBₙₘ zwischen den seriell verschalteten Batteriezellen 9₁₁ ... 9ₙₘ auch einzeln zu- oder wegeschaltet werden. Die Schalter SB₁₁ ... SBₙₘ können dabei auch von der Steuereinheit 10 gesteuert werden.

Wenn ein Zell-Gleichstrom-Gleichstromwandler 6₁₁ ... 6ₙₘ als bidirektionaler Gleichstrom-Gleichstromwandler ausgeführt ist, kann damit auch auf Energiespeichereinheit (Batteriezelle) entladen werden.

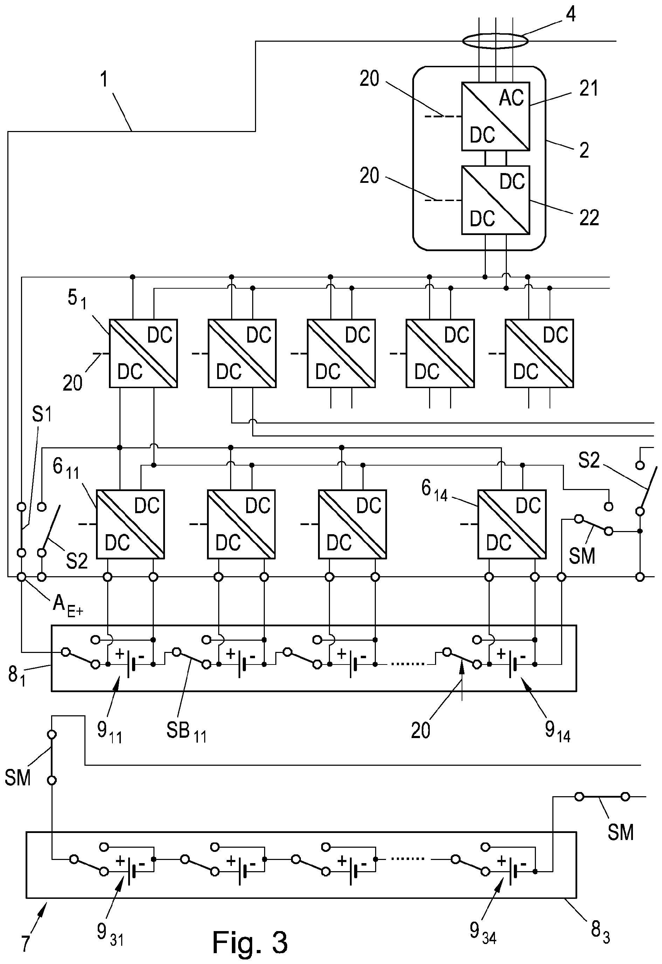

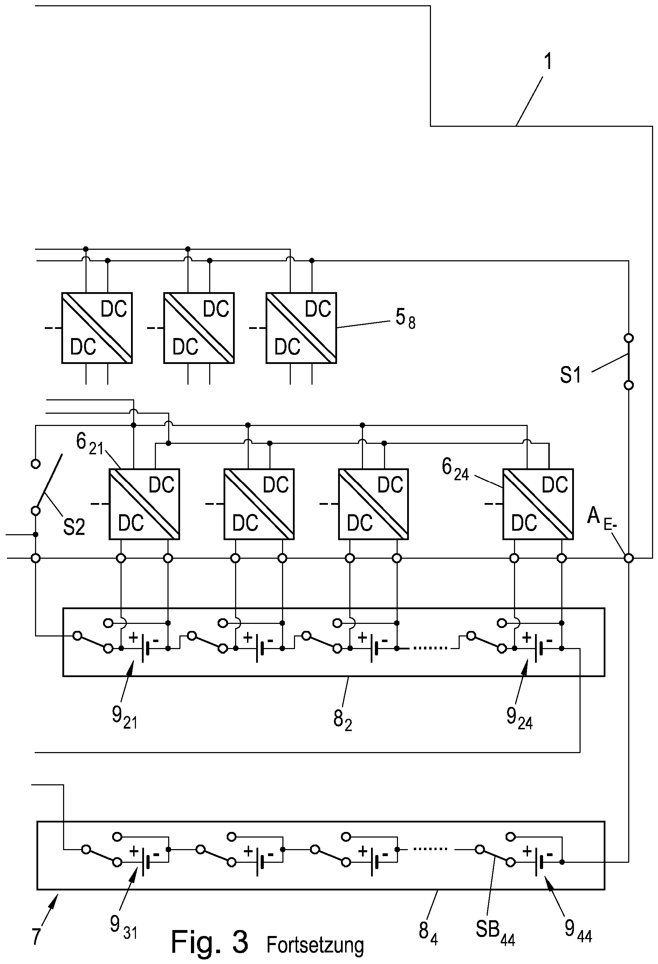

Fig.3 zeigt die Verwendung der Prüfanordnung 1 in einem Testsystem mit einem Batteriepack 7 (Energiespeicher) aus vier Batteriemodulen 8₁ ... 8₄ (Energiespeichermodule) zu je vier, über die Schalter SB₁₁ ... SB₄₄ jeweils in Serie geschalteten Batteriezellen 9₁₁ ... 9₄₄ (Energiespeichereinheiten). Die einzelnen Batteriemodule 8₁ ... 8₄ sind über Schalter SM in Serie geschaltet. Dazu sind die Schalter S1 auf Energiespeicherebene geschlossen und die Schalter S2 auf Energiespeichermodulebene geöffnet. Der Wechselstrom-Gleichstromwandlers 2 ist hier zweistufig ausgeführt, mit einem eingangsseitigen Wechselstrom-Gleichstromwandler 21 und einen damit verbundenen Gleichstrom-Gleichstromwandler 22.

## Patentansprüche

1. Prüfanordnung für einen Energiespeicher mit zumindest einem Energiespeichermodul mit einer Mehrzahl von Energiespeichereinheiten, mit einem Wechselstrom-Gleichstromwandler (2) der eingangsseitig mit einer Spannungsversorgung (3) verbunden ist und ausgangsseitig mit zumindest einem bidirektionalen isolierten Modul-Gleichstrom-Gleichstromwandler (5₁ ... 5ₙ) verbunden ist, wobei der Ausgang des bidirektionalen isolierten Modul-Gleichstrom-Gleichstromwandlers (5₁ ... 5ₙ) mit einer Mehrzahl von parallel geschalteten Zell-Gleichstrom-Gleichstromwandlern (6₁₁ ... 6ₙₘ) verbunden ist und die Ausgänge der Zell-Gleichstrom-Gleichstromwandler (6₁₁ ... 6ₙₘ) als Ausgänge (A₁₊, A₁₋ ... Aₓ₊, Aₓ₋) der Prüfanordnung (1) nach außen geführt sind, **dadurch gekennzeichnet, dass** mehrere Modul-Gleichstrom-Gleichstromwandler (5₁ ... 5ₙ) parallel an den Ausgang des Wechselstrom-Gleichstromwandlers (2) angeschlossen sind, wobei jeder Modul-Gleichstrom-Gleichstromwandler (5₁ ... 5ₙ) mit einer Mehrzahl von parallel geschalteten Zell-Gleichstrom-Gleichstromwandlern (6₁₁ ... 6ₙₘ) verbunden ist und die Ausgänge der Modul-Gleichstrom-Gleichstromwandler (5₁ ... 5ₙ) über Schalter (SM) in Serie verschaltbar sind, oder die Ausgänge (A₁₊, A₁₋ ... Aₓ₊, Aₓ₋) mehrerer Zell-Gleichstrom-Gleichstomwandler (6₁₁ ... 6ₙₘ) über Schalter (SZ) in Serie verschaltbar sind.

2. Prüfanordnung nach Anspruch 1, **dadurch gekennzeichnet, dass** die Ausgänge der Modul-Gleichstrom-Gleichstromwandler (5₁ ... 5ₙ) über einen Schalter (S2) als Ausgänge (A_{M1+}, A_{M1-} ... A_{Mn+}, A_{Mn-}) der Prüfanordnung (1) nach außen geführt sind.

3. Prüfanordnung nach Anspruch 1, **dadurch gekennzeichnet, dass** die Ausgänge der in Serie geschalteten Zell-Gleichstrom-Gleichstromwandler (6₁₁ ... 6ₙₘ) über einen Schalter (S3) als Ausgänge (A_{Z1+}, A_{Z1-} ... A_{Zx+}, A_{Zx-}) der Prüfanordnung (1) nach außen geführt ist.

4. Prüfanordnung nach einem der Ansprüche 1 bis 3, **dadurch gekennzeichnet, dass** die Ausgänge des Wechselstrom-Gleichstromwandlers (2) über einen Schalter (S1) als Ausgänge (A_{E+}, A_{E-}) der Prüfanordnung (1) nach außen geführt sind.

5. Verwendung der Prüfanordnung (1) nach einem der Ansprüche 1 bis 4 zum Testen oder Formieren eines Energiespeichers bestehend aus zumindest einem Energiespeichermodul mit zumindest einer Energiespeichereinheit, **dadurch gekennzeichnet, dass** die zumindest eine Energiespeichereinheit des Energiespeichermoduls mit einem Ausgang (A₁₊, A₁₋ ... Aₓ₊, Aₓ₋) eines Zell-Gleichstrom-Gleichstromwandlers (6₁₁ ... 6ₙₘ) verbunden ist.

6. Verwendung nach Anspruch 5, **dadurch gekennzeichnet, dass** zumindest zwei Energiespeichereinheiten des Energiespeichers in Serie geschaltet sind und jede Energiespeichereinheit mit einem Ausgang (A₁₊, A₁₋ ... Aₓ₊, Aₓ₋) eines Zell-Gleichstrom-Gleichstromwandlers (6₁₁ ... 6ₙₘ) verbunden ist.

7. Verwendung nach Anspruch 6, **dadurch gekennzeichnet, dass** die beiden Energiespeichereinheiten über einen Schalter (SB₁₁ ... SBₙₘ) miteinander verbunden sind.

8. Verwendung nach einem der Ansprüche 5 bis 7, **dadurch gekennzeichnet, dass** zumindest zwei Energiespeichermodule in Serie geschaltet sind.

9. Verwendung nach einem der Ansprüche 5 bis 8, **dadurch gekennzeichnet, dass** die Ausgänge (A_{M1+}, A_{M1-} ... A_{Mn+}, A_{Mn-}) eines Modul-Gleichstrom-Gleichstromwandlers (5₁ ... 5ₙ) mit den seriell verschalteten Ausgängen (A_{Z1+}, A_{Z1-} ... A_{Zx+}, A_{Zx-}) der zugehörigen in Serie geschalteten Zell-Gleichstrom-Gleichstromwandler (6₁₁ ... 6ₙₘ) verbunden sind.

10. Verwendung nach Anspruch 9, **dadurch gekennzeichnet, dass** die Zell-Gleichstrom-Gleichstromwandler (6₁₁ ... 6ₙₘ) inaktiv geschaltet sind.

11. Verwendung nach Anspruch 9, **dadurch gekennzeichnet, dass** zumindest ein Zell-Gleichstrom-Gleichstromwandler (6₁₁ ... 6ₙₘ) einen Laststrom erzeugt.

## Claims

1. A test arrangement for an energy storage device having at least one energy storage module with a plurality of energy storage units, having an AC/DC converter (2) which is connected on the input side to a power supply (3) and which is connected on the output side to at least one bidirectional isolated module DC/DC converter (5₁ ... 5ₙ), wherein the output of the bidirectional isolated module DC/DC converter (5₁ ... 5ₙ) is connected to a plurality of parallel-connected cell DC/DC converters (6₁₁ ... 6ₙₘ) and the outputs of the cell DC/DC converters (6₁₁ ... 6ₙₘ) are brought out as outputs (A₁₊, A₁₋ ... Aₓ₊, Aₓ₋) of the test arrangement (1), **characterized in that** a plurality of module DC/DC converters (5₁ ... 5ₙ) are connected in parallel to the output of the AC/DC converter (2) wherein each module DC/DC converter (5₁ ... 5ₙ) is connected to a plurality of parallel-connected cell DC/DC converters (6₁₁ ... 6ₙₘ) and the outputs of the module DC/DC converters (5₁ ... 5ₙ) are connectable in series by means of switches (SM) or the outputs of a plurality of cell DC/DC converters (6₁₁ ... 6ₙₘ) are connectable in series by means of switches (SZ).

2. The test arrangement as claimed in claim 1, **characterized in that** the outputs of the module DC/DC converters (5₁ ... 5ₙ) are brought out via a switch (S2) as outputs (A_{M1+}, A_{M1-} ... A_{Mn+}, A_{Mn-}) of the test arrangement (1).

3. The test arrangement as claimed in claim 1, **characterized in that** the outputs of the series-connected cell DC/DC converters (6₁₁ ... 6ₙₘ) are brought out via a switch (S3) as outputs (Azi+, A_{Z1-} ... A_{Zx+}, A_{Zx-}) of the test arrangement (1).

4. The test arrangement as claimed in one of claims 1 to 3, **characterized in that** the outputs of the AC/DC converter (2) are brought out via a switch (S1) as outputs (A_{E+}, A_{E-}) of the test arrangement (1).

5. A use of the test arrangement (1) as claimed in one of claims 1 to 4 for testing or forming an energy storage device consisting of at least one energy storage module having at least one energy storage unit, **characterized in that** the at least one energy storage unit of the energy storage module is connected to an output (A₁₊, A₁₋ ... Aₓ₊, Aₓ₋) of a cell DC/DC converter (6₁₁ ... 6ₙₘ).

6. The use as claimed in claim 5, **characterized in that** at least two energy storage units of the energy storage device are connected in series and each energy storage unit is connected to an output (A₁₊, A₁₋ ... Aₓ₊, Aₓ₋) of a cell DC/DC converter (6₁₁ ... 6ₙₘ).

7. The use as claimed in claim 6, **characterized in that** the two energy storage units are connected to one another by means of a switch (SB₁₁ ... SBₙₘ).

8. The use as claimed in one of claims 5 to 7, **characterized in that** at least two energy storage modules are connected in series.

9. The use as claimed in one of claims 5 to 8, **characterized in that** the outputs (A_{M1+}, A_{M1-} ... A_{Mn+}, A_{Mn-}) of a module DC/DC converter (5₁ ... 5ₙ) are connected to the series-connected outputs (Azi+, A_{Z1-} ... A_{Zx+}, A_{Zx-}) of the associated series-connected cell DC/DC converters (6₁₁ ... 6ₙₘ).

10. The use as claimed in claim 9, **characterized in that** the cell DC/DC converters (6₁₁ ... 6ₙₘ) are deactivated.

11. The use as claimed in claim 9, **characterized in that** at least one cell DC/DC converter (6₁₁ ... 6ₙₘ) generates a load current.

## Revendications

1. Montage d'essai pour un accumulateur d'énergie comportant au moins un module d'accumulation d'énergie comportant une pluralité d'unités d'accumulation d'énergie, comportant un convertisseur alternatif-continu (2) qui est relié côté entrée à une alimentation en tension (3) et qui est relié côté sortie à au moins un convertisseur continu-continu de module (5₁... 5ₙ) isolé dans les deux sens, la sortie du convertisseur continu-continu de module (5₁... 5ₙ) isolé dans les deux sens étant reliée à une pluralité de convertisseurs continu-continu d'éléments (6₁₁... 6ₙₘ) montés en parallèle, et les sorties des convertisseurs continu-continu d'éléments (6₁₁... 6ₙₘ) étant amenées à l'extérieur en tant que sorties (A₁₊, A₁₋ ... Aₓ₊, Aₓ₋) du montage d'essai (1), **caractérisé en ce que** plusieurs convertisseurs continu-continu de module (5₁... 5ₙ) sont connectés en parallèle à la sortie du convertisseur alternatif-continu (2), chaque convertisseur continu-continu de module (5₁... 5ₙ) étant relié à une pluralité de convertisseurs continu-continu d'éléments (6₁₁... 6ₙₘ) montés en parallèle, et les sorties des convertisseurs continu-continu de module (5₁... 5ₙ) pouvant être montées en série par l'intermédiaire d'interrupteurs (SM), ou les sorties (A₁₊, A₁₋ ... Aₓ₊, Aₓ₋) de plusieurs convertisseurs continu-continu d'éléments (6₁₁... 6ₙₘ) pouvant être montées en série par l'intermédiaire d'interrupteurs (SZ).

2. Montage d'essai selon la revendication 1, **caractérisé en ce que** les sorties des convertisseurs continu-continu de module (5₁... 5ₙ) sont amenées à l'extérieur par l'intermédiaire d'un interrupteur (S2) en tant que sorties (A_{M1+}, A_{M1-} ... A_{Mn+}, A_{Mn-}) du montage d'essai (1).

3. Montage d'essai selon la revendication 1, **caractérisé en ce que** les sorties des convertisseurs continu-continu d'éléments (6₁₁... 6ₙₘ) montés en série sont amenées à l'extérieur par l'intermédiaire d'un interrupteur (S3) en tant que sorties (A_{Z1+}, A_{Z1-}... A_{Zx+}, A_{Zx-}) du montage d'essai (1).

4. Montage d'essai selon l'une des revendications 1 à 3, **caractérisé en ce que** les sorties du convertisseur alternatif-continu (2) sont amenées à l'extérieur par l'intermédiaire d'un interrupteur (S1) en tant que sorties (AE+, A_{E-}) du montage d'essai (1).

5. Utilisation du montage d'essai (1) selon l'une des revendications 1 à 4 pour tester ou former un accumulateur d'énergie composé d'au moins un module d'accumulation d'énergie comportant au moins une unité d'accumulation d'énergie, **caractérisée en ce qu'au** moins une unité d'accumulation d'énergie du module d'accumulation d'énergie est reliée à une sortie (A₁₊, A₁₋ ... Aₓ₊, Aₓ₋) d'un convertisseur continu-continu d'éléments (6₁₁... 6nm).

6. Utilisation selon la revendication 5, **caractérisée en ce qu'**au moins deux unités d'accumulation d'énergie de l'accumulateur d'énergie sont montées en série, et **en ce que** chaque unité d'accumulation d'énergie est reliée à une sortie (A₁₊, A₁₋ ... Aₓ₊, Aₓ₋) d'un convertisseur continu-continu d'éléments (6₁₁... 6ₙₘ).

7. Utilisation selon la revendication 6, **caractérisée en ce que** les deux unités d'accumulation d'énergie sont reliées entre elles par l'intermédiaire d'un interrupteur (SB₁₁... SBₙₘ).

8. Utilisation selon l'une des revendications 5 à 7, **caractérisée en ce qu'**au moins deux modules d'accumulation d'énergie sont montés en série.

9. Utilisation selon l'une des revendications 5 à 8, **caractérisée en ce que** les sorties (A_{M1+}, A_{M1}... A_{Mn+}, A_{Mn-}) d'un convertisseur continu-continu de module (5₁... 5ₙ) sont reliées aux sorties montées en série (A_{Z1+}, A_{Z1-}... A_{Zx+}, A_{Zx-}) des convertisseurs continu-continu d'éléments (6₁₁... 6ₙₘ) associés montés en série.

10. Utilisation selon la revendication 9, **caractérisée en ce que** les convertisseurs continu-continu d'éléments (6₁₁... 6ₙₘ) sont désactivés.

11. Utilisation selon la revendication 9, **caractérisée en ce qu'**au moins un convertisseur continu-continu d'éléments (6₁₁... 6ₙₘ) génère un courant de charge.
